(19) **Europäisches Patentamt / European Patent Office / Office européen des brevets**

(11) **EP 1 639 657 B1**

(12) **EUROPEAN PATENT SPECIFICATION**

(45) Date of publication and mention
of the grant of the patent:
**15.07.2009 Bulletin 2009/29**

(21) Application number: **04710575.4**

(22) Date of filing: **12.02.2004**

(51) Int Cl.:
**H01L 41/24** (2006.01)

(86) International application number:
**PCT/SG2004/000038**

(87) International publication number:
**WO 2005/004249 (13.01.2005 Gazette 2005/02)**

(54) **METHOD OF PRODUCING PIEZOELECTRIC TUBES**

VERFAHREN ZUR HERSTELLUNG PIEZOELEKTRISCHER RÖHREN

METHODE POUR PRODUIRE DES TUBES PIEZOELECTRIQUES

(84) Designated Contracting States:
**AT BE BG CH CY CZ DE DK EE ES FI FR GB GR
HU IE IT LI LU MC NL PT RO SE SI SK TR**

(30) Priority: **01.07.2003 US 611401**

(43) Date of publication of application:
**29.03.2006 Bulletin 2006/13**

(60) Divisional application:
**08104575.9 / 1 976 039**

(73) Proprietor: **Nanyang Technological University
Singapore 639798 (SG)**

(72) Inventors:
• **MA, Jan**
**Singapore 610367 (SG)**
• **BOEY, Yin Chiang**
**Singapore 288685 (SG)**

(74) Representative: **Finnie, Peter John
Gill Jennings & Every LLP
Broadgate House
7 Eldon Street
London EC2M 7LH (GB)**

(56) References cited:
**EP-A2- 1 215 737          JP-A- 8 336 967
US-A1- 2002 024 270     US-B1- 6 349 455**

• **PATENT ABSTRACTS OF JAPAN vol. 1997, no. 04, 30 April 1997 (1997-04-30) -& JP 08 336967 A (FUJI ELECTRIC CO LTD), 24 December 1996 (1996-12-24)**
• **MORITA T ET AL: "An ultrasonic micromotor using a bending cylindrical transducer based on PZT thin film" SENSORS AND ACTUATORS A, ELSEVIER SEQUOIA S.A., LAUSANNE, CH, vol. 50, no. 1-2, August 1995 (1995-08), pages 75-80, XP004303516 ISSN: 0924-4247**
• **MORITA T ET AL: "A CYLINDRICAL MICRO ULTRASONIC MOTOR USING PZT THIN FILM DEPOSITED BY SINGLE PROCESS HYDROTHERMAL METHOD (PHI 2.4MM, L = 10 mm STATOR TRANSDUCER)" IEEE TRANSACTIONS ON ULTRASONICS, FERROELECTRICS AND FREQUENCY CONTROL, IEEE SERVICE CENTER, PISCATAWAY, NJ, US, vol. 45, no. 5, September 1998 (1998-09), pages 1178-1187, XP000801799 ISSN: 0885-3010**
• **MORITA ET AL.: 'A cylindrical micro ultrasonic morot using PZT thin film deposited by single process huydrothermal method' IEEE TRANSACTIONS ON ULTRASONICS, FERROELECTRICS AND FREQUENCY CONTROL vol. 45, no. 5, September 1998, pages 1178 - 1187, XP000801799**
• **PATENT ABSTRACTS OF JAPAN & JP 2002 252391 A (MATSUSHITA ELECTRIC IND CO) 06 September 2002**

EP 1 639 657 B1

**Description**

**Field of the Invention**

The invention relates to a method for forming piezoelectric tubes, and in particular, for forming piezoelectric tubes suitable for use as transducers, as used for example in heart pumps, or the like.

**Description of the Related Art**

The reference to any prior art in this specification is not, and should not be taken as, an acknowledgement or any form of suggestion that the prior art forms part of the common general knowledge.

It is known in some practical applications of actuators and transducers, to use tubular piezoelectric components.

For example, a tubular transducer is a piezoelectric ceramic tube coated with electrodes both on the outer and inner surfaces. The outer electrode may be sectioned into quadrants along the longitudinal direction, with the inner electrode being grounded to allow movement of the electrode to be achieved by applying currents to selected quadrants of the outer electrode. Such configurations can be used in many situations, such as a tube scanner in scanning tunneling microscope (STM) and driving component in cylindrical ultrasonic motor.

A tube scanner, as proposed by Binning and Smith in "Single-tube three-dimensional scanner from scanning tunneling microscopy". Rev Sci. Instrum. 57, 1688-1989, operates to move in the x, y and z direction with sub-nanometer resolution by extension and contraction of the functional part under an applied electric field. This design offers advantages of good structural rigidity, easy calibration and high resonance frequency.

Currently, piezoelectric tubes of this form are produced using techniques such as injection molding, extrusion, and drilling holes through solid piezoelectric rods.

However, these fabrication techniques typically suffer from a number of disadvantages. For example, it is usually difficult to ensure material uniformity using these techniques. Furthermore, thin-walled, small-sized tubes are usually difficult to produce due to constraints on the manipulation of the piezoelectric materials in this fashion.

In another example described by Higuchi et al in Sensors and Actuators A, 50,75 (1995), and 83 225 (2000), in IEEE Transactions on Ultrasonics, Ferroelectrics, and Frequency Control, 45,1178 (1998) and in IEEE Ultrasonics Symposium, 549 (1994) and 671 (1998) a functional tubular transducer was fabricated using a hydrothermal method. This involves depositing film on a titanium tube substrate.

Whilst this method allows for miniaturization without poling, it has the drawback of limited density (<3 g/cm$^3$) of the deposited film and the transducer size is also constrained by the titanium tube.

US2002/0024270A1 describes a method for forming a piezoelectric/electrostrictive film element at low temperature using electrophoretic deposition. The method includes preparing a suspension containing ceramic elements submerging a substrate into the suspension and performing electrophoretic deposition to form the piezoelectric/electrostrictive film element and thermally treating the element so produced. US6349455B1 describes a similar method.

JP8-336967 discloses a piezoelectric actuator comprising piezoelectric tubes around a hollow metal rod, the tubes being produced by hydrothermal crystallisation. Takeshi Morita et al "An ultrasonic micromotor using a bending cylindrical transducer based on PZT thin film", Sensors and Actuators A, vol. 50, p. 75-80, (1995), XP 4303516 describes an ultrasonic motor consisting of a short cylindrical titanium pipe on which a lead zirconate titanate (PZT) thin film is deposited by a hydrothermal method. Takeshi Morita et al., "A Cylindrical Micro Ultrasonic Motor Using PZT Thin Film Deposited by Single Process Hydrothermal Method ($\phi$ 2.4mm, L=10 mm Stator Transducer)", IEEE Transactions on Ultrasonics, Ferroelectrics, and Frequency Control, vol. 45, no.5, p. 1178-1187, (1998), XP 801799 describes an improvement to the method, which uses only a single process instead of two linked processes.

As the development of small scale applications, and the use of piezoelectric tubes in integrated circuitry increases, there is a need for techniques of producing such miniaturized tubes accurately with high quality, and relatively cheaply.

**Summary of the Invention**

The invention provides a method of forming a multi-layered piezoelectric tube, the method including: forming a suspension of ceramic particles in a fluid medium, positioning a rod in the fluid medium; depositing particles on the rod using electrophoresis to form a first layer; applying a metallic paste to an outer surface of the first layer formed from the deposited particles to form an intermediate electrode; depositing further particles on the rod using electrophoresis to form another layer on the rod; and heat-treating the deposited particles to form the piezoelectric tube.

Preferably, prior to the step of heat-treating the method further includes performing at least once the steps of: applying a metallic paste to an outer surface of the outer layer of deposited particles to form another intermediate electrode; and, depositing further particles using electrophoresis to form another layer on the rod.

The method of depositing the particles may include: positioning the rod in a container containing the suspension; connecting the rod to a first terminal of a power supply; connecting an electrode to a second terminal of the power supply, the electrode being in contact with the fluid medium; and using the power supply to apply a predetermined DC voltage to the electrode and the rod to thereby cause at least some of the particles to be deposited on the rod.

The container can be a conductive container adapted to act as the electrode. Alternatively, a separate electrode could be used.

If the container is the electrode, the container can be formed from at least one of stainless steel, copper, and another metal. Alternatively, the container can be formed form at least one of glass and plastic, the container being coated with at least one conductive layer.

The method of heat-treating the deposited particles typically includes: heating the deposited particles to a first predetermined temperature to thereby solidify the particles to a surface of the rod and burn off the rod, to thereby leave a tube of solidified particles, the tube being closed at one end; and heating the tube to a second predetermined to thereby sinter the tube to form a dense ceramic tube.

The method may further include cutting off the closed end of the tube.

The second predetermined temperature is preferably higher than the first predetermined temperature. The first predetermined temperature can be between 500°C and 1000°C. The second predetermined temperature can be between 850°C and 1300°C.

The rod may be formed from graphite, although other materials may be used, including at least one of plastic and another material that can be burnt off at the first predetermined temperature, in which case the rod is coated with at least one conductive layer.

The method may further include using a magnetic stirrer to prevent sedimentation of the particles in the suspension.

The method of forming the suspension may further include: dispersing the particles into a solvent to form the suspension and adjusting the pH value of said suspension to a predetermined pH value.

The solvent may be an organic solvent, such as at least one of ethanol and acetone. Alternatively, other solvents such as water may be used.

The method of dispersing the particles may further include dispersing the particles ultrasonically.

The method can also include adding a stabilizer, such as ether glycol to the suspension.

In general, the particles are at least one of lead zirconate titanate; doped lead zirconate titanate; $BaTiO_3$; $0.95Pb(Zr_{0.52}Ti_{0.48})O_3 \cdot 0.03BiFeO_3 \cdot 0.02Ba(Cu_{0.5}W_{0.5})O_3 + 0.5wt\%$ $MnO_2$; and other piezoelectric particles.

The method may further include applying metallic paste to the inner and outer surfaces of the piezoelectric tube; and, poling the piezoelectric tube to thereby form a transducer.

The poling conditions can include the application of an electrical field in the region of $2 \sim 4$ kV/mm, for between $20 \sim 120$ minutes duration and at temperature 100 to 150°C.

**Brief Description of the Drawings**

Examples of the invention will now be described with reference to the accompanying drawings, in which:

Figure 1 is a schematic diagram of an example of apparatus for producing piezoelectric tubes;
Figure 2 is an example of an alternative electrode arrangement for use in the apparatus of Figure 1;
Figure 3 is a schematic view of the rod of Figure 1 coated with a layer of ceramic particles; and,
Figure 4 is a cross sectional view of a piezoelectric tube produced using the apparatus of Figure 1;
Figure 5 is an SEM microstructure of the piezoelectric tube of Figure 4;
Figure 6 is an X-ray radiography photo for different tube sizes;
Figure 7A is a schematic side view of an example of a transducer;
Figure 7B is a schematic plan view of the transducer of Figure 7A;
Figure 8 is a schematic diagram of an example of apparatus for measuring the displacement of a transducer;
Figure 9 is a graph used in the determination of piezoelectric constant $d_{31}$ for a transducer;
Figures 10A and 10B are schematic diagrams of the coordinate system used for measuring the free-boundary end modes of transverse oscillation of a transducer;
Figure 11 is a graph showing the displacement response for a tube produced according to a first specific example;
Figure 12 is an example of the coordinate system used when measuring free-free end modes of oscillation of a transducer;
Figure 13 is a graph showing the bending displacement in response to a step voltage;
Figure 14 is a graph showing a comparison of calculated and measured end displacement of a tube produced according to the first specific example of Figure 7;
Figure 15 is a schematic plan view of a second example of a transducer produced according to the invention;

Figure 16 is a cross sectional view of an example of a double layer piezoelectric tube;

Figure 17 is XRD pattern of the piezoelectric tube of Figure 16;

Figure 18 is an SEM microstructure of the piezoelectric tube of Figure 16;

Figure 19 is an example of the configuration of a double layered transducer;

Figure 20 is a graph showing the longitudinal displacement of a double layered transducer;

Figure 21 is a graph showing the bending displacement of a double layered transducer;

Figure 22 is a graph showing a comparison between the theoretical and measured bending displacement of a double layered transducer under the condition $V_2=0$;

Figure 23 is a graph showing a comparison between the theoretical and measured bending displacement of a double layered transducer under the condition $V_1=0$;

Figure 24 is a graph showing a comparison between the bending displacement of a single and double layered transducer under the condition $V_1=V_2=V$; and,

Figure 25 is a graph showing the variation in the bending displacement of a double layered transducer for a varying intermediate radius $r_2$.

## Detailed Description of the Preferred Embodiment

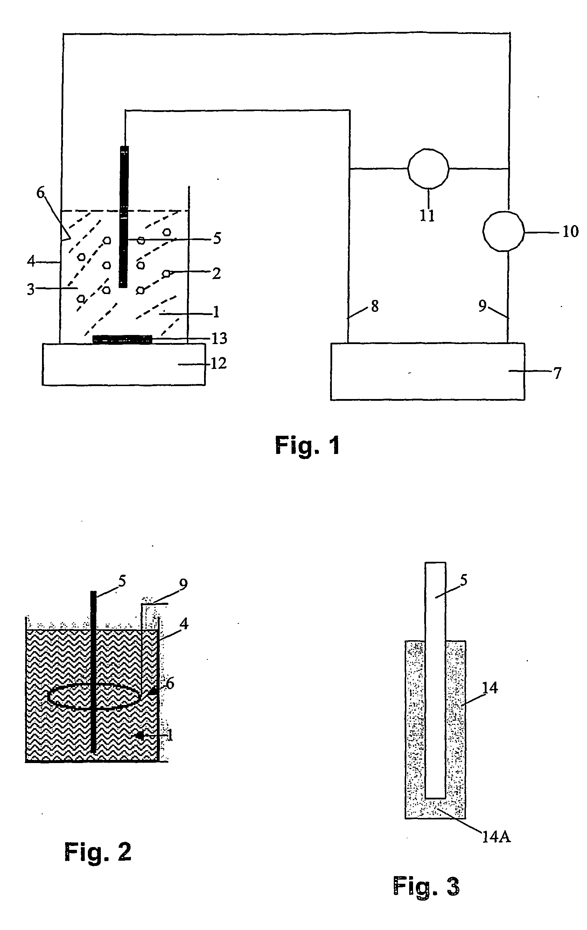

An example of apparatus for forming piezoelectric tubes is shown in Figure 1.

As shown the apparatus includes a container 4, adapted to hold a stable colloidal suspension 1, formed from a number of particles 2 held in suspension within a solvent 3. A rod 5 is adapted to be positioned within the fluid suspension 1, as shown. An electrode 6 is also provided, with the electrode 6 and the rod 5 being coupled to a power supply 7, via respective leads 8, 9.

Typically an ammeter 10 and a voltmeter 11 are provided to allow the current and voltage applied to the rod 5 and the electrode 6 to be measured.

Finally, the container 4 is positioned on a magnetic stirrer 12, which is adapted to cause rotation of a magnetic bar 13, positioned in the container 13 to allow the suspension to be stirred in use.

In this example, the container is formed from an electrically conductive material, and accordingly, the container 4 acts as the electrode 6. However, it is also possible to provide a separate electrode 6, as shown for example in Figure 2.

In use, the apparatus allows the particles to be deposited on the rod using electrophoretic deposition (EPD). The manner in which this may be achieved will now be described.

In particular, the particles 2, which are piezoelectric ceramic particles, such as lead zirconate titanate (PZT), doped lead zirconate titanate (PZT), $BaTiO_3$, or the like, are dispersed into the solvent 3 to form the suspension 1. The nature of the solvent will depend on the specific implementation, and the particles 2, although typically organic solvents, such as ethanol and acetone, are used. However alternative solvents, such as water, may also be used if appropriate.

Once the particles are suspended within the solvent, the pH value of the suspension is adjusted by adding either an acid or a base. Generally the pH value of the suspension is adjusted to be in the range between pH 4 to 5.

In order to avoid agglomeration of the particles, it is preferable for the particles 2 in the suspension 1 to be ultrasonically dispersed. Furthermore, stabilizers, such as ester glycol can be added to the suspension 1, before the suspension 1 is transfer into the container 4.

The container 4 is typically placed on the magnetic stirrer 12, with the magnetic bar 13 positioned in the bottom of the container 4, as shown. This allows the suspension 1 to be stirred, thereby helping to avoid sedimentation of the particles during the process.

The rod 5 is then connected to the power supply 7, using the lead 8 before being inserted into the suspension 1 to act as an electrode. Similarly the other electrode 6 is positioned in contact with the suspension 1. This is achieved either by inserting the electrode 6 into the container 4, as in the case of Figure 2, or simply by connecting the container 4 to the power supply 7 using the lead 9 in Figure 1.

In this latter case, the container 4 can be formed from stainless steel, copper, or any other metal that is sufficiently unreactive, so as not to impact on the EPD process. Alternatively, the container 4 can be formed from plastic/glass coated with one or more conductive layers.

Similarly, the rod 5 can be formed from graphite or plastic coated with one or more conductive layer or layers.

The particles held in suspension will hold a charge, the polarity of which depends on the pH level of the fluid medium. In this example, the particles have a positive charge because the pH level is acidic.

When the DC power supply 7 is activated, an electric potential is generated between the rod 5 and the electrode 6. In particular, the rod 5 is connected to the negative terminal of the power supply, so that the rod acts as a cathode and becomes negatively charged. Similarly the electrode 6 acts as the positively charged anode.

The particles having a positive charge are therefore attracted to the rod 5. In this regard, it is preferred that the electrode 6 surrounds the rod 5, so as to generate an even potential gradient extending radially outwardly from the rod 5. This ensures that the particles are attracted to the rod evenly from all directions.

Accordingly, the particles are attracted to, and hence become deposited evenly over the surface of the rod. Adjusting the voltage and current applied to the rod 5 and the electrode 6 can be used to control the thickness and quality of the deposited layer, as well as the rate of deposition, as will be appreciated by persons skilled in the art. Thus for example, increasing the current density or the voltage will lead to an increase in the rate of deposition.

After deposition, the rod 5 is coated with a layer of ceramic particles, as shown for example at 14 in Figure 3. The rod 5 is removed from the suspension 1 and dried in air for a predetermined time period, which will vary depending on factors, such as the thickness of the deposited layer.

At this point, if a dual layer tube is to be produced, once the deposits have been thoroughly dried, the outer surface of the deposited layer can be painted with a uniform layer of metallic paste, such as platinum paste. A second layer of deposition can be performed to produce a second ceramic layer.

It will be appreciated that this process may be repeated any number of times to form a multi-layered tube, with each layer being separated using appropriate intermediate electrodes. Thus, for a piezoelectric tube having N layers (where N≥2), there will be provided N-1 intermediate electrodes, with additional inner and outer electrodes being provided, as will be described in more detail below.

In any event, once the desired number of layers are provided, the dried rod 5 and particle layer 14 (it will be appreciated that a number of layers may be present, but only one will be described for clarity purposes) is then fired by heating in a furnace at a first temperature, to thereby solidify the particle layer 14, and burn away the rod 5, to thereby leave the particle layer 14 intact. The first temperature is typically between 500°C and 1200°C, and it will therefore be appreciated that the rod 5 must be made of material that can burn within this temperature range.

After the rod has been removed, the particle layer 14 forms a tube, having one closed, as shown at 14A in Figure 3.

The tube is then sintering at a second higher temperature to form a dense ceramic tube. This is typically performed at temperatures between 850°C and 1300°C, depending on factors such as the thickness of the particle layer 14.

The tube is then allowed to cool, before having the closed end removed, to thereby form a hollow tube open at both ends, as will be appreciated by persons skilled in the art.

After poling, in which the piezoelectric tube is exposed to an electric field, the tube may be used as a transducer, an actuator, or the like. The poling conditions will vary depending on the intended use of the piezoelectric tube. Thus, for example, if the tube is to be used as a pump transducer, typical poling conditions will include the application of an electrical field in the region of 2 - 4 kV/mm, for between 20 ~ 120 minutes duration and at temperature 100 to 150°C. This may be performed in silicon oil.

First Example

A first example of the conditions used in the formation of a single layer piezoelectric transducer tube, suitable for use in an STM, or as a pump transducer, as described for example in the co-pending patent application entitled "Pump", (filed as serial no. 60/415844, attorney docket number DAVI190.001PRF filed October 02, 2002) not being part of the present invention will now be described.

In particular, in this example, the ceramic used to fabricate the transducer is a hard material with a composition of $0.95Pb(Zr_{0.52}Ti_{0.48})O_3\ 0.03BiFeO_3\ 0.02Ba(Cu_{0.5}W_{0.5})O_3 + 0.5wt\%MnO_2$. This is formed by mixing raw oxide powders of PbO(>99.9%), $ZrO_2$(>99.9%), $TiO_2$(>99.9%), $BiO_3$(>99.99%), $Fe_2O_3$(>99%), BaO (>99%), CuO(>99.99%), $WO_2$ (>99%) and $MnO_2$(>99.99%) with the required stoichiometrical composition and then ball-milling the mixture for 24 hours. Due to the volatility of PbO during sintering, an additional 5% of PbO can be added into the raw powders. The mixed powders are then calcined at 750 °C for 2 hours. Finally, the calcined powders were ground by a planetary ball-milling machine at a speed of 150 rpm in ethanol for 8 hours. This process results in the ground powders having a mean particle size of 1.4 $\mu$m which can be determined using an acoustic particle sizer.

To prepare the piezoelectric suspension, a conductive container, whose diameter can be 40 to 100 mm, is used. 3 to 5 grams of the piezoelectric powder, $0.95Pb(Zr_{0.52}Ti_{0.48})O_3 \cdot 0.03BiFeO_3 \cdot 0.02Ba(Cu_{0.5}W_{0.5})O_3 + 0.5wt\%MnO_2$. is mixed with 200 to 300 ml ethanol in the container. 2 to 5 drops of 5% $HNO_3$ is also added to adjust the pH value of the suspension.

The suspension is dispersed using an ultrasonic cleaner for 6 minutes, although longer time frames of 20 to 40 minutes may be used, to break up agglomerates. After dispersion, the piezoelectric suspension is ready for electrophoretic deposition (EPD).

In this example the powder concentration in the suspension is 50 g/l and the suspension pH is controlled to be 4 or 4.6 at room temperature. The suspension may also be stirred for 3 to 6 hours to further ensure the complete dissolution and dispersion of the powders in the medium.

In this example, the conductive container is used as the anode, with the rod 5 having a diameter of between 0.3 to 25mm, being used as the cathode.

The distance between the two electrodes is adjusted to between 20 to 50 mm. A DC voltage with the range of 10 to 100 V is applied between the container 4 and the rod 5, during which time the suspension is stirred with a magnetic stirrer 12 at a moderate speed to avoid the sedimentation of the powder particles.

Under these conditions, the process takes between 3 to 30 minutes to deposit a layer of particles on the conductive rod depending on the required thickness and applied voltage. Thus, at a higher voltage of 100V, a duration of 3 to 8 minutes may typically be used. After being thoroughly dried for 12 to 48 hours at ambient temperature, the deposited sample is heat-treated in a furnace to burn off the carbon rod 5. The temperature for heat treatment can be set in the range of 700 to 1200 °C, and the holding time is about 10 to 100 minutes.

The piezoelectric tube is finally produced by sintering the heat-treated sample at higher temperature of between 1100 and 1300 °C, for 1 to 3 hours, in an enriched atmosphere. In particular, the PZT material is an oxide and can be sintered in normal air environment, however, to reduce the loss of lead, which is a low melting point material, a lead enriched environment is preferred to ensure the described stoichiometry of the product.

In this example, the deposits are dried for 12 hours and then sintered in a programmable furnace at 1100 °C for 1 hour.

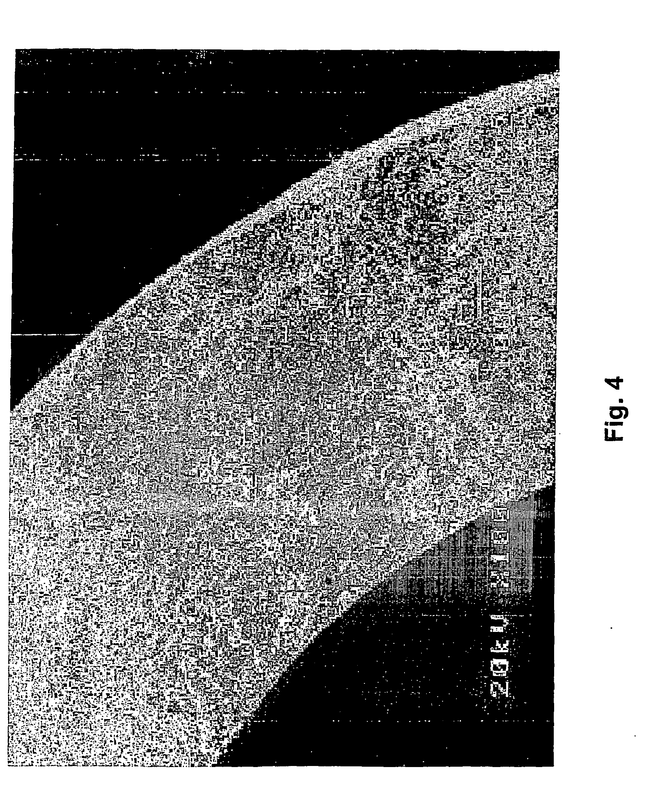

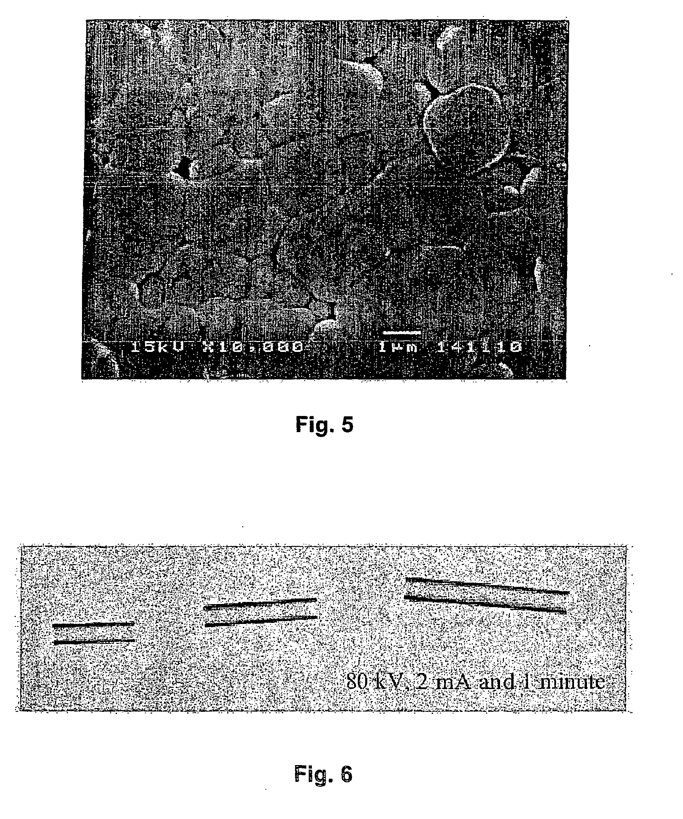

An example of a cross section through a resulting piezoelectric tube is shown in Figure 4. A second cross section at a higher magnification is shown in Figure 5, with X-ray photos of examples of different sized tubes being shown in Figure 6. The cross section in Figure 5 was obtained using an SEM micrograph of the sintered PZT tube. The sample was polished and then thermal etched at 1025°C for 15 minutes. It can be seen that the grain size was grown from around 1.4 $\mu$m to about 5 $\mu$m. The density of the tube was measured to be 7.54 g/cm$^3$ using an electronic densimeter, which is approximately 95% of the theoretical maximum value. This demonstrates that the density achieved using this technique is greatly improvement compared to other techniques such as the hydrothermal method.

The X-ray radiology photograph shown in Figure 6 also highlights that the structures reasonably uniform in diameter and wall thickness.

Thus, as shown, the tube has a substantially constant structure, and thickness, with no discontinuities, or other faults, thereby ensuring good material strength and durability, as well as ensuring consistency between different piezoelectric tubes produced using the method.

Accordingly, the process describe above provides a technique for manufacturing piezoelectric tubes that may be used as actuators or transducers.

In order to be used as a transducer for piezoelectric pump, the sintered tube is cut into the designed length and brush-painted with silver paste to form inner and outer electrodes, before firing at 850°C for 20 minutes. Poling was next carried out in silicone oil at 100 °C by applying a DC field of 2 kV/mm along the radial thickness direction for 2 hours.

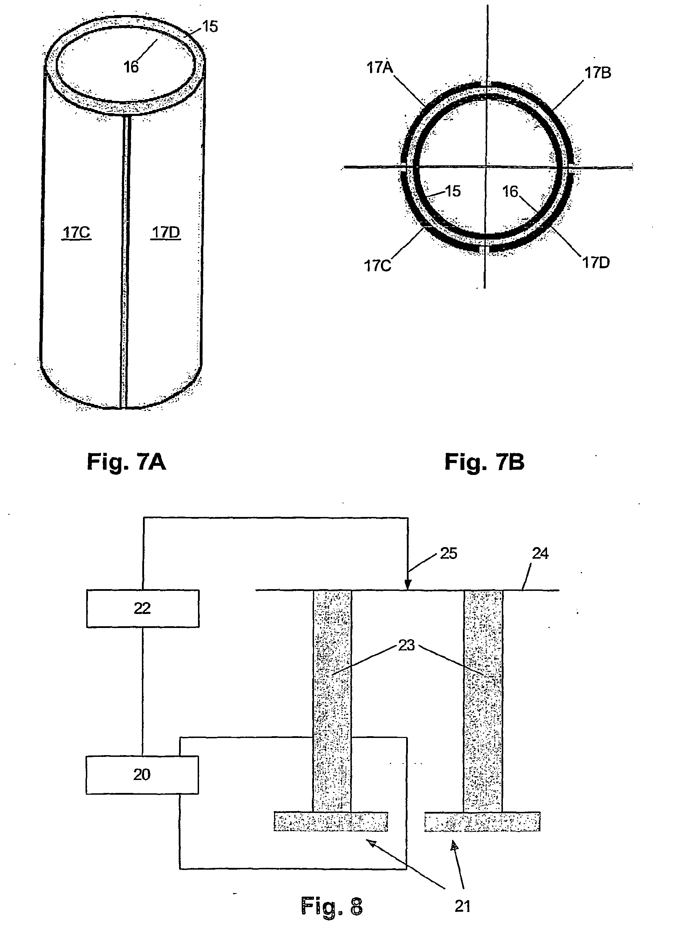

An example of a completed transducer is shown in Figures 7A and 7B. As shown the transducer includes a ceramic tube 15, a single inner electrode 16, and an outer electrode 17, having four quadrants 17A, 17B, 17C, 17D.

The process is simple, economical, and compact compared with other fabrication methods, thereby allowing piezoelectric transducers to be formed more rapidly, and reliably than using conventional techniques.

Another advantage is.that the dimension of product can be adjusted and controlled in a wide range, which depends on the diameter selection of the conductive rod and the processing parameters (applied voltage, current, and deposition time).

Performance

The piezoelectric constant $d_{31}$ of a tubular transducer is given by the standard equations:

$$S_1 = d_{31}E_3 \qquad\qquad (1)$$

where $S_1$ is the strain in the length direction of the tube given by:

$$S_1 = \frac{\Delta L}{L} \qquad\qquad (2)$$

where AL and L are transducer displacement and length respectively.

$E_3$ is the average electric field, and this is given by:

$$E_3 = \frac{2V}{(r_o + r_i)\ln\frac{r_o}{r_i}}$$

(3)

where V is voltage added to the wall thickness direction; $r_o$ and $r_i$ are the outer and inner radius of the transducer respectively.

The displacement of the transducer can be measured using apparatus shown in Figure 8. In particular, the apparatus includes a ferroelectric test system 20, such as a Radiant Technologies, Inc. RT6000HVS, a vibraplane 21, a fotonic sensor 22, such as a probe MTI2032RX. MTI Instrument and the piezoelectric tube 23 assembled as shown.

The whole area of both the inner and outer surfaces of the piezoelectric tube was painted with silver paste to act as conducting electrodes. One end of the tube was fixed to the vibraplane 21 with epoxy in order to avoid any vibration-induced errors. The other end was attached with a reflection mark 24. The fotonic sensor probe 22 was targeted at the center of the mark as shown by arrow 25 and placed parallel to the longitudinal direction. During measurement, a bipolar step voltage was applied in the wall thickness direction of the tube 23 by the test system 20. The step voltage was increased from zero to maximum set voltage V, then decreased to negative maximum set voltage -V, and finally return to zero. The fotonic sensor then measured the displacement $\Delta L$ of the tube in response to the given voltage. 100 points were measured in a single voltage cycle.

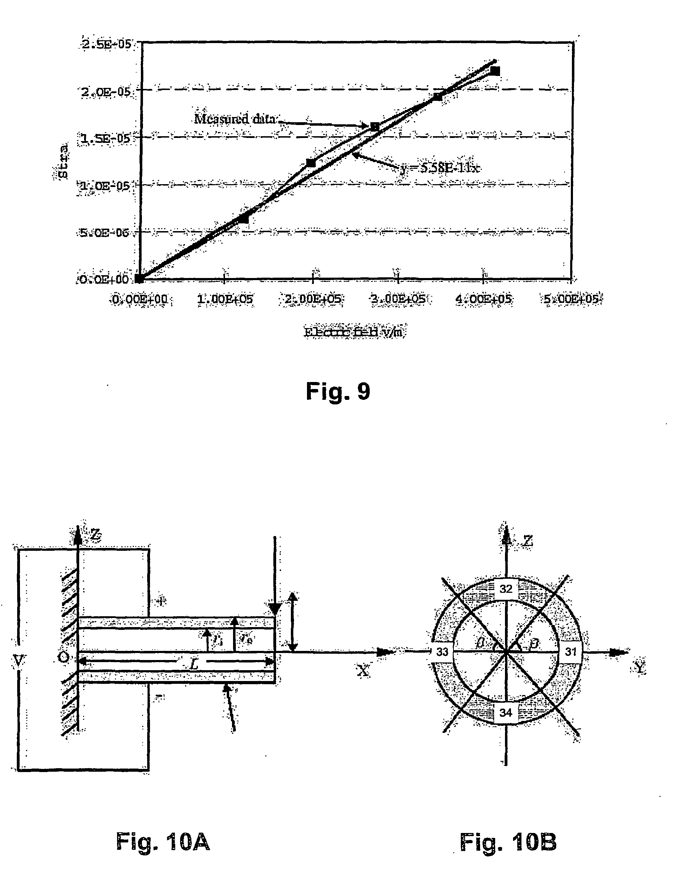

The measured displacement AL as a function of the set voltage V is shown in Figure 9, with the slope being defined using by equation.

$$y = 5.58 \times 10^{-11} x$$

(4)

The slope of 5.58x10-11 provides the $d_{31}$ value of the material. This value indicates that the EPD technique can produce piezoelectric ceramic tubes ideally suited for use as a transducer, with the EPD technique having several other advantages over the traditional method such as the flexibility in component shape and ability to produce smaller component (<1mm).

The bending displacement of the piezoelectric tube with clamped-free and free-free end conditions were derived and experimentally verified for the using apparatus similar to that shown above with respect to Figure 8. In this case, the coordinate system used for the derived equations is as shown in Figures 10A, and 10B. The origin O of the system lies at one end of the tube 23, as shown in Figure 10A. The neutral plane, X-Y plane, passes through the origin O. The transverse displacement takes place along the Z direction. As shown in Figure 10B, the electroded driving parts 32 and 34, and the unelectroded driven parts 31 and 33, are aligned mirror-symmetrically according to the Z-axis. Angle $\beta$, which determines the driving parts area, varies from 0 to 90°.

The tensile or compressive stress and strain along the longitudinal direction are denoted as T1 and S1 for the driving parts and T1' and S1' for the driven parts, respectively. According to the piezoelectric relationship, the stresses along the X-axis are expressed to be:

$$T_1 = \frac{1}{s_{11}^E} S_1 - \frac{d_{31}}{s_{11}^E} E_3$$

(5)

$$T_1' = \frac{1}{s_{11}^E} S_1'$$

(6)

where $S_{11}^E$ is the elastic compliance constant. The electric field in thickness direction E3 is expressed as:

$$E_3 = \frac{V}{r \ln \frac{r_o}{r_i}}$$

(7)

where r is radius between outer radius $r_o$ and inner radius $r_i$.

Assuming that the cross section keeps plane under deflection, $S_1$ can be written as:

$$S_1 = -z \frac{1}{\rho} = -z \frac{dz^2}{dx^2}$$

(8)

where $\rho$ is the radius of curvature.

Finally, the bending moment of the a cross section at position x can be expressed as:

$$M = \int_{s1+s3} z T_1' ds + \int_{s2+s4} z T_1 ds$$

(9)

Putting Equation 5 to 8 into 9, gives:

$$M = -\frac{\pi}{4\rho s_{11}^E}\left(r_o^4 - r_i^4\right) - \frac{2d_{31}V}{s_{11}^E \ln \frac{r_o}{r_i}}\left(r_o^2 - r_i^2\right)\cos\beta$$

(10)

Since in the static equilibrium condition the total bending moment over a cross section is zero, i.e., M = 0, this requires:

$$\frac{1}{\rho} = -\frac{8d_{31}V\cos\beta}{\pi\left(r_o^2 + r_i^2\right)\ln \frac{r_o}{r_i}}$$

(11)

As the radius of curvature keeps constant in the static situation, and since:

$$\frac{1}{\rho} = \frac{dz^2}{dx^2}$$

(12)

it can be derived from Equation 4 that:

$$\frac{dz}{dx} = \frac{1}{\rho}x + C$$

(13)

$$z = \frac{1}{2}\frac{1}{\rho}x^2 + Cx + D \tag{14}$$

where C and D are constants.

The constant C and D can be determined by considering the clamped-free end, and the free-free end boundary conditions. In the clamped-free end boundary conditions:

$$\begin{cases} \dfrac{dz}{dx} = 0 \\ z = 0 \end{cases} \tag{15}$$

it is obtained that C=D=0.

Thus, the maximum displacement at the free tip end is obtained to be:

$$\zeta = \frac{L^2}{2\rho} = -\frac{4d_{31}V \cos \beta L^2}{\pi\left(r_o{}^2 + r_i{}^2\right)\ln \dfrac{r_o}{r_i}} \qquad 0 < \beta < \frac{\pi}{2} \tag{16}$$

The relation between the displacement and piezoelectric constant $d_{31}$, angle $\beta$, voltage V and length L can then be obtained from Equation 16.

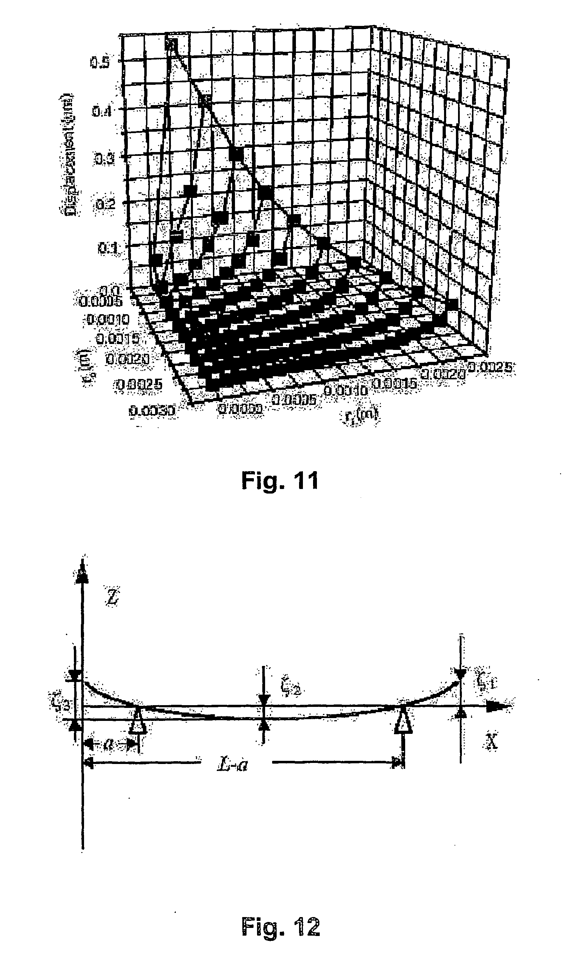

Figure 11 shows an illustration of the displacement with respect to changes of radius $r_o$ and $r_i$. The parameters used are $d_{31}$ = -4.5x10$^{-11}$ m/V, L=10 mm, $\beta$=45° and V=30V. The outer radius $r_o$ varies from 0.5 to 2.5 mm. The inner radius $r_i$ varies from near zero to 0.95 of the outer radius. It can be concluded from the present analysis that for the same outer radius, with increasing the inner radius, the displacement increases; and the larger the outer radius, the smaller the displacement for the same inner radius.

In the case of the free-free end boundary conditions, the transducer was supported at the two nodal points a and L-a as shown in Figure 12. The nodal point is the position where the displacement is zero at resonance frequency. Thus, following the same procedure as in clamped-free condition and using the boundary conditions:

$$\begin{cases} \dfrac{dz}{dx}\Big|_{x<0.5L} = -\dfrac{dz}{dx}\Big|_{L-x} \\ z = 0\Big|_{x-a,L-a} \end{cases} \tag{17}$$

The shape equation can be derived to be:

$$z = \frac{1}{2\rho}\left[\left(x - \frac{L}{2}\right)^2 - \left(a - \frac{L}{2}\right)^2\right] \tag{18}$$

Thus, the displacement can be calculated as:

$$\begin{cases} \zeta_1 = \dfrac{1}{2\rho} a(L-a) \\ \zeta_2 = -\dfrac{1}{2\rho}\left(a-\dfrac{L}{2}\right)^2 \\ \zeta_3 = \dfrac{L^2}{8\rho} \end{cases}$$

$$(19)$$

It can be seen that as the functional displacement $\zeta_1$ is reduced, the total deflection $\zeta_3$ is equal to one quarter of the tip displacement in clamped-free condition. As a result, the clamped-free end condition is a better design to be used for the motor in terms of displacement. This has also offered method for miniaturization of the functional transducer since a clamped-free transducer provides larger displacement for the same size. In addition, the clamped-free end condition tube has lower resonant frequency compared with free-free configuration tube.

In order to verify the above-derived equations, the end displacement of the clamped-free transducer was measured. The transducer set up and the measurement procedure is the same as that is used for $d_{31}$ measurement shown in Figure 10A. However, the outer electrode is divided into 4 parts, and the angle $\beta$ is equal to 45°.

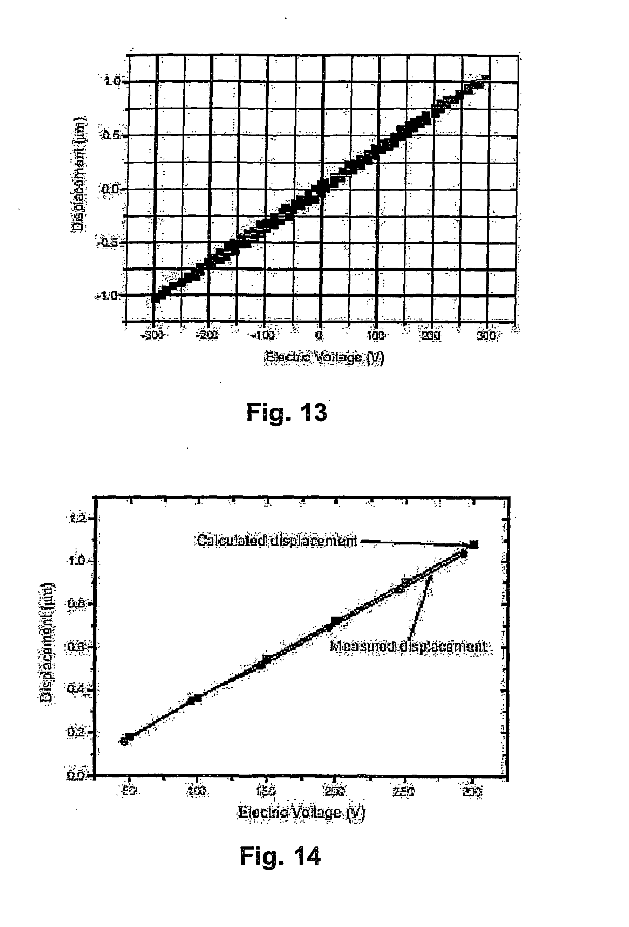

Figure 13 shows one cycle of the displacement in response to the step voltage under a given set value 300 V. A good linear property with small hysteresis is clearly shown for a typical hard material. Figure 14 shows the comparison of the measured results and the calculated results using Equation 16 for the displacement under 300 V. The applied parameters are tabulated in Table 1, below.

Table 1

| Outer radius $r_o$ (mm) | Inner radius $r_1$ (mm) | Length L (mm) | Angle $\beta$° | $d_{31}$ (10-11 m/v) |
|---|---|---|---|---|
| 1.45 | 1.19 | 9.98 | 45 | -5.58 |

It can be seen that the calculated value is in good agreement with the measured results.

Accordingly electrophoretic deposition is shown to be a good method to fabricate small, dense bulk piezoelectric tube with desired perovskite phase and fine microstructure to be used as tubular transducer. The static bending displacement with clamped-free and free-free end conditions have indicated that:

The bending displacement is proportional to the piezoelectric constant d31, the voltage V added in the thickness direction, the square of transducer length L and cosβ (0<β<π/2);

At a given outer radius, the displacement increases with increase of the inner radius; the larger the outer radius, the smaller the displacement for the same inner radius;

The transverse displacement will decrease when the boundary conditions changes from clamped-free to free-free.

This makes the resultant tubes ideal for use as transducer, for example for use in a pump.

Second Specific Example

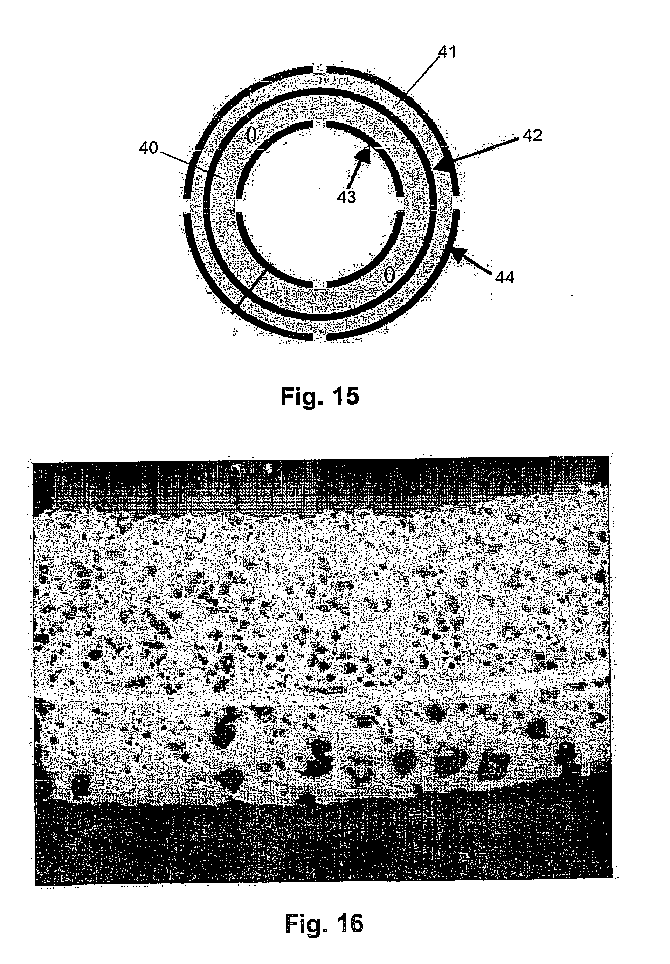

In the case in which the produced piezoelectric tubes are used in STMs or as transducers in piezoelectric motors, large displacement is desirable to achieve a larger scanning range or higher rotational speed and torque, respectively. This can be achieved using a double-layered tubular transducer, an example of which is shown in Figure 15. In this example the double-layered transducer includes first and second ceramic layers 40, 41 separated by an intermediate electrode 42 inner and outer electrodes 43, 44 are also provided and are sectioned into quadrants as shown. The fabrication process is substantially similar to that described above with respect to the single layer transducer, and will not therefore be described in detail.

In particular, the first ceramic layer is deposited on the rod 5, as described above. The deposited layer is dried thoroughly, and then painted with uniform platinum paste before a second layer of deposition is performed. In this case, the EDP current may be applied to the rod or the platinum paste layer, depending on the implementation. After drying for 12 hours, the dual deposit layers are sintered in a programmable furnace at 1100°C for 1 hour.

The sintered tube was then cut into the designed length and painted with silver paste as the inner and outer electrodes before firing at 850°C for 20 minutes. Poling was next carried out in silicone oil at 100°C by applying a DC field of 2 kV/mm along the radial thickness direction for 2 hours.

Figure 16 shows a segment of the cross section of the piezoelectric tube after sintering, observed using an optical microscope. It can be seen that a reasonably fine and narrow platinum intermediate electrode about 12 $\mu$m separates the two layers. It also demonstrates that EPD is an effective technique to fabricate the double-layered structure. In Figure 16, the electrode is designed to position near the outer surface. By varying the parameters of electrophoretic deposition, the location of the electrode can be adjusted, as will be appreciated by persons skilled in the art.

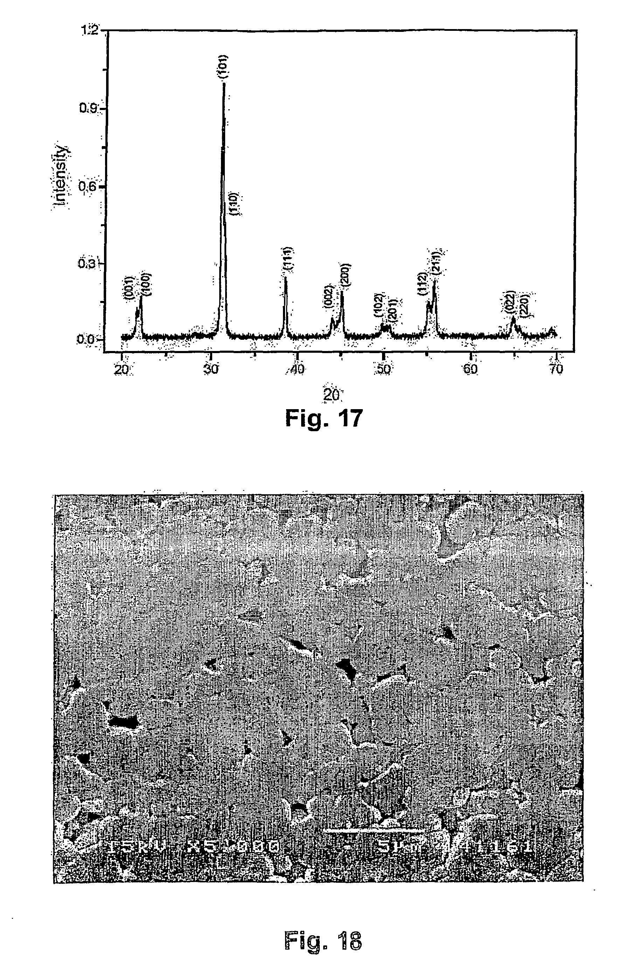

To confirm the composition of the deposited piezoelectric PZT tubes, an XRD measurement was carried out using a Shimadzu XRD-6000 with Cu target under 50.0 kV, 20.0 mA and 2.0000 deg/min scanning speed. Figure 17 illustrates the XRD pattern of the materials after sintering, and the expected tetragonal-phase perovskite structure of PZT was observed.

Figure 18 shows an SEM micrograph of cross section of the piezoelectric tube. The average grain size is evaluated to be approximately 2.6 $\mu$m. Some residual pores were also observed. The density is measured to be 7.639 g/cm3 using an electronic densimeter (MD-200s), which is 96.7% of the theoretical value. The results have shown that the piezoelectric tube has been sintered to a relatively dense state.

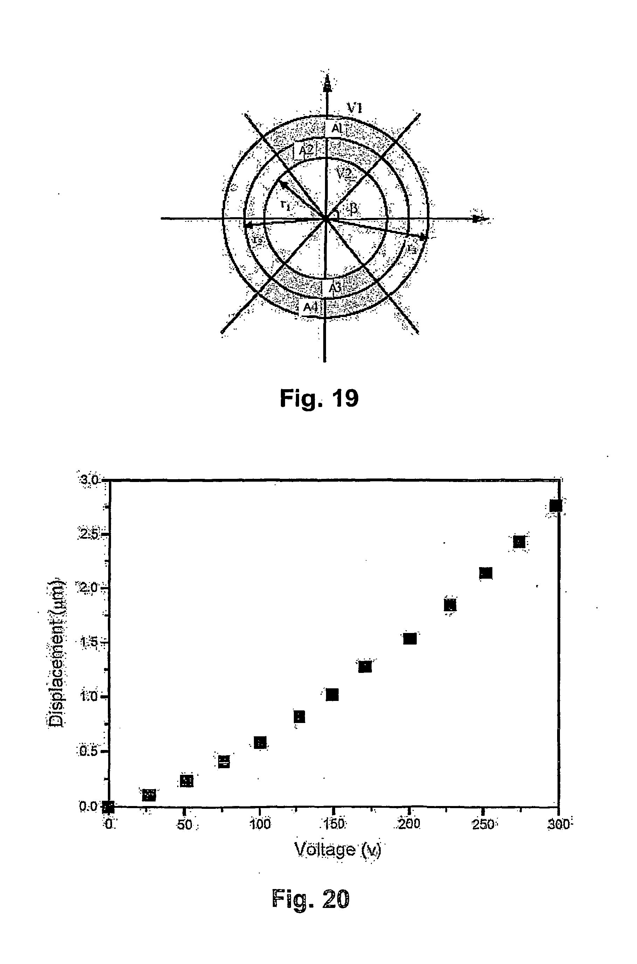

Figure 19 illustrates the cross section layout of the double-layered tubular transducer. In use, the intermediate electrode $r_2$ is grounded. The areas A1 to A4 are the driving parts. They are applied with voltage V1 and V2, respectively. In both designs, angle $\beta$ determines the driving area of the transducer.

Deriving equations in a manner similar to that described above, the bending displacement of the double-layered transducer under Clamped-Free boundary condition is:

$$\zeta = -\frac{4d_{31}V_1(r_3^2 - r_2^2)\cos\beta L^2}{\pi(r_3^4 - r_1^4)(\ln r_3 - \ln r_2)} - \frac{4d_{31}V_2(r_2^2 - r_1^2)\cos\beta L^2}{\pi(r_3^4 - r_1^4)(\ln r_2 - \ln r_1)} \qquad 0 \le \beta \le \frac{\pi}{2} \tag{20}$$

The relation between the displacement $\zeta$ and piezoelectric constant $d_{31}$, angle $\beta$, voltage V (V1 and V2), length L, inner radius $r_1$, intermediate radius $r_2$ and outer radius $r_3$ can be easily obtained from the equations.

A tubular transducer with dimensions listed in Table 2 below was used to measure the bending displacement.

Table 2

| L (mm) | $r_1$ (mm) | $r_2$ (mm) | $r_3$ (mm) | $\beta$ (Degree) |
|---|---|---|---|---|
| 12.08 | 1.61 | 1.78 | 1.87 | 0 |

The intermediate radius $r_2$ was measured under optical microscope. The apparatus used for displacement measurement is similar to that described above and will not be described in detail.

Figure 20 shows the longitudinal displacement under different voltages. A perfect straight line was not observed as expected. This is because the material is not hard enough to keep linear properties under high electric field and hence displays certain not-linearity. The maximum electric field is estimated to be more than 1150 V/mm at 300 V. However, since the displacement is basically a straight line when the applied voltage is below 100 V, the data below this voltage were applied to determine $d_{31}$ using the standard relationship

$$S_1 = d_{31}E_3 \tag{21}$$

Applying Equation (3), $d_{31}$ is calculated to be $1.18 \times 10^{10}$ m/V.

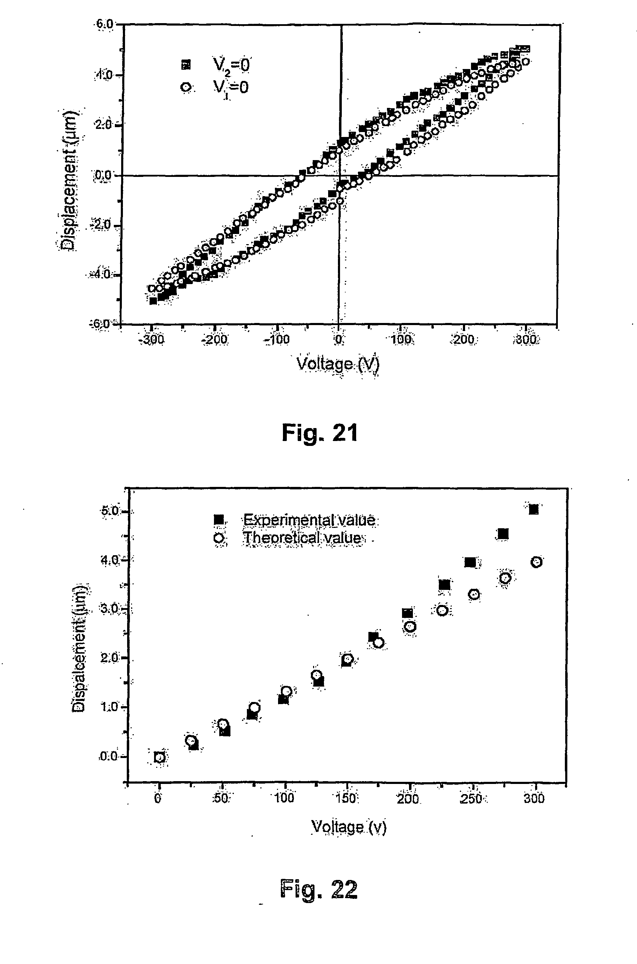

The bending displacements for two situations, $V_1 = 0$ and $V_2 = 0$, in Equation (20) were also measured experimentally. Figure 21 shows one cycle of the displacement in response to the step voltage under a maximum applied voltage of 300 V ($V_1 = 0$, $V_2 = 300$; V2 = 0, V1 = 300). Both curves have shown low electromechanical loss, which is caused by the domain wall motion. As shown the resulting hysteresis is small.

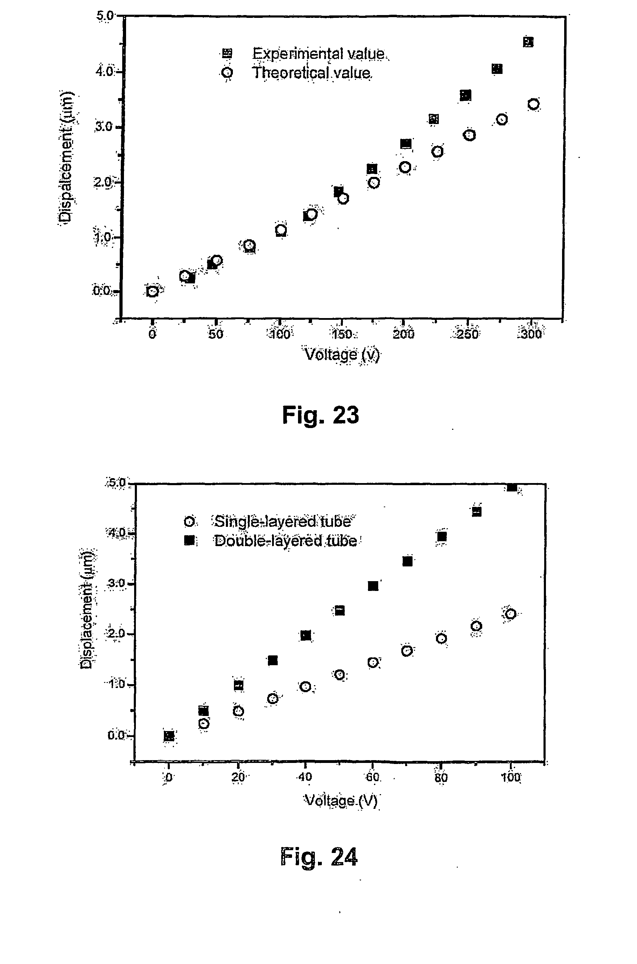

Figures 22 and 23 show the comparison between the theoretical and experimental value for the two conditions $V_1 = 0$ and $V_2 = 0$, respectively. These two figures show the same trend as that observed in Figure 20, i.e., in the lower voltage range, the experimental value keeps basically good consistency with the theoretical value. However as the voltage goes up to 300 V, the material exhibits strong non-linearity and the deviation between the theoretical predictions and the experimental measurements becomes large.

The bending displacement between the double-layered system and the single-layered system can be compared using equations (16) and (20). Figure 24 shows the theoretical bending predictions of the two systems. It is found that the bending displacement can be significantly increased if the double-layered system is applied. The enhancement is approximately doubled under the same driving voltage.

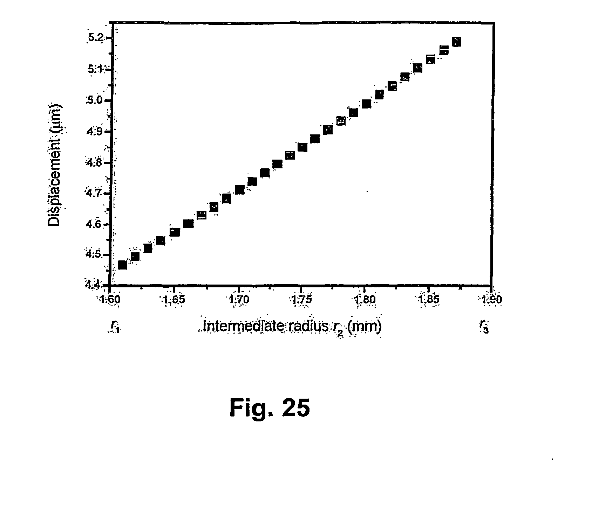

Figure 25 shows an illustration of the displacement with respect to changes in intermediate radius $r_2$. It can be found that the displacement increase linearly when $r_1$ increases to $r_3$. The maximum enhancement is measured to be 16%. As a result, it is also shown that the bending displacement can also be increased by increasing the intermediate radius $r_2$ for a same transducer dimensions.

Accordingly electrophoretic Deposition has been shown to be a good method to fabricate a double-layered piezoelectric tubular transducer. The bending displacement of the double-layered tubular transducer was found to be in good agreement with the theoretical predictions within the linear range and much larger than bending displacement obtainable with a single layer transducer.

It will be appreciated that the technique can be further extended to provide multi-layered tubes having N layers (where N>2), with the multi-layered tubes having even further enhanced bending displacement properties.

**Claims**

1.  A method of forming a multi-layered piezoelectric tube, the method including the steps of:

    (a) forming a suspension (1) of ceramic particles (2) in a fluid medium (3),
    (b) positioning a rod (5) in the fluid medium;
    (c) depositing particles on the rod by electrophoresis to form a first layer;
    (d) applying a metallic paste to an outer surface of the first layer formed from the deposited particles to form an intermediate electrode;
    (e) depositing further particles using electrophoresis to form another layer on the rod; and
    (f) heat-treating the deposited layers to form the piezoelectric tube.

2.  A method according to claim 1, wherein prior to the step of heat-treating the method further includes performing at least once the steps of:

    (a) applying a metallic paste to an outer surface of the outer layer of deposited particles to form another intermediate electrode; and
    (b) depositing further particles using electrophoresis to form another layer on the rod.

3.  A method according to claim 1 or 2, wherein after each step of depositing particles to form a layer and prior to a subsequent step of applying a metallic paste to the outer surface of the deposited layer to form an intermediate electrode, the method further includes the step of drying the deposited particles.

4.  A method according to claim 1, the method further including:

    (a) applying metallic paste to the inner and outer surfaces of the piezoelectric tube; and
    (b) poling the piezoelectric tube to thereby form a transducer.

5.  A method according to claim 4, the poling conditions including the application of an electrical field in the region of 2~4kV/mm, for between 20-120 minutes duration and at temperature in the range 100 to 150°C.

6.  A method according to any one of claims 1 to 5, the method of depositing the particles including:

    (a) positioning the rod in a container containing the suspension;
    (b) connecting the rod to a first terminal of a power supply;
    (c) connecting an electrode to a second terminal of the power supply, the electrode being in contact with the fluid medium; and
    (d) using the power supply to apply a predetermined DC voltage to the electrode and the rod to thereby cause at least some of the particles to be deposited on the rod.

7.  A method according to claim 6, the container being a conductive container adapted to act as the electrode.

8. A method according to claim 7, the container being formed from at least one of stainless steel, copper, and another metal.

9. A method according to claim 7, the container being formed from at least one of glass and plastic, the container being coated with at least one conductive layer.

10. A method according to any preceding claim , wherein the step of heat-treating the deposited particles includes:

   (a) heating the deposited particles to a first predetermined temperature to thereby solidify the particles to a surface of the rod and burn the rod, to thereby leave a tube of solidified particles, the tube being closed at one end; and
   (b) heating the tube to a second predetermined temperature to thereby sinter the tube to form a dense ceramic tube.

11. A method according to claim 10, the method further including cutting off the closed end of the tube.

12. A method according to claim 10, the second predetermined temperature being higher than the first predetermined temperature.

13. A method according to claim 10, the first predetermined temperature being between 500 and 1200°C.

14. A method according to claim 10, the second predetermined temperature being between 850 and 1300°C.

15. A method according to any one of claims 1 to 14, the rod being formed from graphite.

16. A method according to claim 10, the rod being formed from at least one of plastic and another material that can be burnt off at the first predetermined temperature, the rod being coated with at least one conductive layer.

17. A method according to any one of claims 1 to 16, the method further including using a magnetic stirrer to prevent sedimentation of the particles in the suspension.

18. A method according to any one of claims 1 to 17, the method of forming the suspension including:

   (a) dispersing the particles into a solvent to form the suspension; and
   (b) adjusting the pH value of said suspension to a predetermined pH value.

19. A method according to claim 18, the solvent being an organic solvent.

20. A method according to claim 19, the solvent being at least one of ethanol and acetone.

21. A method according to claim 18, the solvent being water.

22. A method according to claim 18, the method of dispersing the particles including dispersing the particles ultrasonically.

23. A method according to claim 18, the method including adding a stabilizer to the suspension.

24. A method according to claim 23, the stabilizer being ether glycol.

25. A method according to any one of claims 1 to 24, the particles being at least one of:

   (a) lead zirconate titanate;
   (b) doped lead zirconate titanate;
   (c) $BaTiO_3$;
   (d) $0.95Pb(Zr_{0.52}Ti_{0.48})O_3 \cdot 0.03BiFeO_3 \cdot 0.02Ba(Cu_{0.5}W_{0.5})O_3 + 0.5wt\ \%MnO_2$; and
   (e) other piezoelectric particles.

**Patentansprüche**

1. Verfahren zum Ausbilden eines mehrschichtigen piezoelektrischen Rohrs, wobei das Verfahren die Schritte umfasst:

(a) Ausbilden einer Aufschlämmung (1) aus keramischen Teilchen (2) in einem Fluidmedium (3);
(b) Anordnen einer Stange (5) in dem Fluidmedium;
(c) Ablagern der Teilchen auf der Stange durch Elektrophorese, um eine erste Schicht auszubilden;
(d) Aufbringen einer metallischen Paste auf einer Außenoberfläche der ersten Schicht, die aus den abgelagerten Teilchen gebildet ist, um eine Zwischenelektrode auszubilden;
(e) Ablagern weiterer Teilchen unter Verwendung von Elektrophorese, um eine weitere Schicht auf der Stange auszubilden; und
(f) Wärmebehandlung der abgelagerten Schichten, um das piezoelektrische Rohr auszubilden.

2. Verfahren nach Anspruch 1, wobei das Verfahren, vor dem Schritt der Wärmebehandlung, die Durchführung mindestens einer der Schritte umfasst:

(a) Aufbringen einer metallischen Paste auf einer Außenoberfläche der Außenschicht der abgelagerten Teilchen, um eine weitere Zwischenelektrode auszubilden; und
(b) Ablagern weiterer Teilchen unter Verwendung von Elektrophorese, um eine weitere Schicht auf der Stange auszubilden.

3. Verfahren nach Anspruch 1 oder 2, wobei nach jedem Schritt der Ablagerung von Teilchen, um eine Schicht auszubilden, und vor einem nachfolgenden Schritt des Aufbringens einer metallischen Paste auf der Außenoberfläche des abgelagerten Schicht, um eine Zwischenelektrode auszubilden, das Verfahren ferner den Schritt des Trocknens der abgelagerten Teilchen umfasst.

4. Verfahren nach Anspruch 1, wobei das Verfahren ferner umfasst:

(a) Aufbringen einer metallischen Paste auf den Innen- und Außenoberflächen des piezoelektrischen Rohrs; und
(b) Polen des piezoelektrischen Rohrs, um **dadurch** einen Wandler auszubilden.

5. Verfahren nach Anspruch 4, wobei die Polbedingungen das Anlegen eines elektrischen Feldes in dem Bereich von 2 ∼ 4 kV/mm für eine Dauer zwischen 20 ∼ 120 Minuten und bei einer Temperatur in dem Bereich von 100 bis 150°C umfassen.

6. Verfahren nach einem der Ansprüche 1 bis 5, wobei des Verfahren zur Ablagerung der Teilchen umfasst:

(a) Anordnen der Stange in einem Behälter, der die Aufschlämmung enthält;
(b) Verbinden der Stange mit einem ersten Anschluss einer Stromversorgung;
(c) Verbinden einer Elektrode mit einem zweiten Anschluss der Stromversorgung, wobei die Elektrode mit dem Fluidmedium in Kontakt ist; und
(d) Verwenden der Stromversorgung, um eine vorbestimmte Gleichspannung an der Elektrode und der Stange anzulegen, um somit zu veranlassen, dass zumindest einige der Teilchen an der Stange abgelagert werden.

7. Verfahren nach Anspruch 6, wobei der Behälter ein leitfähiger Behälter ist, der ausgelegt ist, als Elektrode zu wirken.

8. Verfahren nach Anspruch 7, wobei der Behälter aus zumindest rostfreiem Stahl, Kupfer und/oder einem weiteren Metall ausgebildet ist.

9. Verfahren nach Anspruch 7, wobei der Behälter aus zumindest Glas und/oder Kunststoff ausgebildet ist, wobei der Behälter mit zumindest einer leitfähigen Schicht beschichtet ist.

10. Verfahren nach irgendeinem vorhergehenden Anspruch, wobei der Schritt der Wärmebehandlung der abgelagerten Teilchen umfasst:

(a) Erwärmen der abgelagerten Teilchen auf eine erste vorbestimmte Temperatur, um somit die Teilchen auf einer Oberfläche der Stange zu härten und die Stange auszubrennen, so dass ein Rohr aus gehärteten Teilchen zurückbleibt, wobei das Rohr an einem Ende geschlossen ist; und

(b) Erwärmen des Rohrs auf eine zweite vorbestimmte Temperatur, um somit das Rohr zu sintern, um ein dichtes keramisches Rohr auszubilden.

**11.** Verfahren nach Anspruch 10, wobei das Verfahren ein Abschneiden des geschlossenen Endes des Rohrs umfasst.

**12.** Verfahren nach Anspruch 10, wobei die zweite vorbestimmte Temperatur höher ist als die erste vorbestimmte Temperatur.

**13.** Verfahren nach Anspruch 10, wobei die erste vorbestimmte Temperatur zwischen 500 und 1200°C liegt.

**14.** Verfahren nach Anspruch 10, wobei die zweite vorbestimmte Temperatur zwischen 850 und 1300°C liegt.

**15.** Verfahren nach einem der Ansprüche 1 bis 14, wobei die Stange aus Graphit gebildet ist.

**16.** Verfahren nach Anspruch 10, wobei die Stange zumindest aus Kunststoff und/oder einem weiteren Material geformt ist, das bei der ersten vorbestimmten Temperatur ausgebrannt werden kann, wobei die Stange mit zumindest einer leitfähigen Schicht beschichtet ist.

**17.** Verfahren nach einem der Ansprüche 1 bis 16, wobei das Verfahren ferner die Verwendung eines magnetischen Rührers umfasst, um ein Absetzen der Teilchen in der Aufschlämmung zu verhindern.

**18.** Verfahren nach einem der Ansprüche 1 bis 17, wobei das Verfahren zur Ausbildung der Aufschlämmung umfasst:

(a) Auflösen der Teilchen in einem Lösungsmittel, um die Aufschlämmung zu bilden; und
(b) Anpassen des pH-Wertes der Aufschlämmung an einen vorbestimmten pH-Wert.

**19.** Verfahren nach Anspruch 18, wobei das Lösungsmittel ein organisches Lösungsmittel ist.

**20.** Verfahren nach Anspruch 19, wobei das Lösungsmittel zumindest Ethanol und/oder Aceton ist.

**21.** Verfahren nach Anspruch 18, wobei das Lösungsmittel Wasser ist.

**22.** Verfahren nach Anspruch 18, wobei das Verfahren zum Auflösen der Teilchen ein Auflösen der Teilchen mittels Ultraschall umfasst.

**23.** Verfahren nach Anspruch 18, wobei das Verfahren das Zugeben eines Stabilisators zur Aufschlämmung umfasst.

**24.** Verfahren nach Anspruch 23, wobei der Stabilisator Glykol ist.

**25.** Verfahren nach einem der Ansprüche 1 bis 24, wobei die Teilchen zumindest eine der folgenden sind:

(a) Blei-Zirkonat-Titanat;
(b) dotiertes Blei-Zirkonat-Titanat;
(c) $BaTiO_3$;
(d) $0,95Pb(Zr_{0,52}Ti_{0,48})O_3 \cdot 0,03BiFeO_3 \cdot 0,02Ba(Cu_{0,5}W_{0,5})O_3 + 0,5Gew\%MnO_2$; und
(e) andere piezoelektrische Teilchen.

**Revendications**

**1.** Procédé de formation d'un tube piézoélectrique multicouche, le procédé comprenant les étapes qui consistent à :

(a) former une suspension (1) de particules céramiques (2) dans un milieu fluide (3),
(b) placer une tige (5) dans le milieu fluide,
(c) par électrophorèse, déposer des particules sur la tige de manière à former une première couche,
(d) appliquer une pâte métallique sur la surface extérieure de la première couche formée des particules déposées, de manière à former une électrode intermédiaire,
(e) déposer d'autres particules par électrophorèse pour former une autre couche sur la tige et

(f) traiter thermiquement les couches déposées de manière à former le tube piézoélectrique.

2. Procédé selon la revendication 1, dans lequel, avant l'étape de traitement thermique, le procédé comprend en outre l'exécution d'au moins l'une des étapes qui consistent à :

(a) appliquer une pâte métallique sur la surface extérieure de la couche extérieure de particules déposées, de manière à former une autre électrode intermédiaire et
(b) déposer d'autres particules par électrophorèse pour former une autre couche sur la tige.

3. Procédé selon les revendications 1 ou 2, dans lequel après chaque étape de dépôt de particules en vue de former une couche et avant une étape ultérieure d'application d'une pâte métallique sur la surface extérieure de la couche déposée de manière à former une électrode intermédiaire, le procédé comporte en outre l'étape qui consiste à sécher les particules déposées.

4. Procédé selon la revendication 1, comprenant en outre les étapes qui consistent à :

(a) appliquer une pâte métallique sur la surface intérieure et la surface extérieure du tube piézoélectrique et
(b) polariser le tube piézoélectrique pour ainsi former un transducteur.

5. Procédé selon la revendication 4, dans lequel les conditions de polarisation comprennent l'application d'un champ électrique de l'ordre de 2 à 4 kV/mm pendant une durée de 20 à 120 minutes et à une température comprise dans la plage de 100 à 150°C.

6. Procédé selon l'une quelconque des revendications 1 à 5, dans lequel l'opération de dépôt des particules comprend les étapes qui consistent à :

(a) placer la tige dans un récipient qui contient la suspension,
(b) relier la tige à une première borne d'une alimentation en énergie,
(c) relier une électrode à une deuxième borne de l'alimentation en énergie, l'électrode étant en contact avec le milieu fluide et
(d) utiliser l'alimentation en énergie pour appliquer une tension continue prédéterminée sur l'électrode et la tige, pour ainsi amener au moins certaines des particules à se déposer sur la tige.

7. Procédé selon la revendication 6, dans lequel le récipient est un récipient conducteur adapté pour jouer le rôle de l'électrode.

8. Procédé selon la revendication 7, dans lequel le récipient est formé d'acier inoxydable, de cuivre et/ou d'un autre métal.

9. Procédé selon la revendication 7, dans lequel le récipient est formé de verre et/ou de matière plastique, le récipient étant revêtu d'au moins une couche conductrice.

10. Procédé selon l'une quelconque des revendications précédentes, dans lequel l'étape de traitement thermique des particules déposées comprend les étapes qui consistent à :

(a) chauffer les particules déposées à une première température prédéterminée pour ainsi solidifier les particules sur la surface de la tige et cuire la tige pour ainsi obtenir un tube de particules solidifiées, le tube étant fermé à une extrémité et
(b) chauffer le tube à une deuxième température prédéterminée pour ainsi fritter le tube de manière à former un tube céramique dense.

11. Procédé selon la revendication 10, qui comprend en outre l'étape qui consiste à découper l'extrémité fermée du tube.

12. Procédé selon la revendication 10, dans lequel la deuxième température prédéterminée est supérieure à la première température prédéterminée.

13. Procédé selon la revendication 10, dans lequel la première température prédéterminée est comprise entre 500 et 1 200°C.

**14.** Procédé selon la revendication 10, dans lequel la deuxième température prédéterminée est comprise entre 850 et 1 300°C.

**15.** Procédé selon l'une quelconque des revendications 1 à 14, dans lequel la tige est formée de graphite.

**16.** Procédé selon la revendication 10, dans lequel la tige est formée de matière plastique et/ou d'un autre matériau qui peut être éliminé par combustion à la première température prédéterminée, la tige étant revêtue d'au moins une couche conductrice.

**17.** Procédé selon l'une quelconque des revendications 1 à 16, qui comprend en outre l'étape qui consiste à utiliser un agitateur magnétique pour empêcher la sédimentation des particules de la suspension.

**18.** Procédé selon l'une quelconque des revendications 1 à 17, dans lequel l'opération de formation de la suspension comprend les étapes qui consistent à :

(a) disperser les particules dans un solvant de manière à former la suspension et
(b) ajuster la valeur du pH de ladite suspension à une valeur prédéterminée du pH.

**19.** Procédé selon la revendication 18, dans lequel le solvant est un solvant organique.

**20.** Procédé selon la revendication 19, dans lequel le solvant est l'éthanol et/ou l'acétone.

**21.** Procédé selon la revendication 18, dans lequel le solvant est l'eau.

**22.** Procédé selon la revendication 18, dans lequel l'opération de dispersion des particules comprend la dispersion des particules par ultrasons.

**23.** Procédé selon la revendication 18, dans lequel le procédé comprend l'addition d'un agent de stabilisation à la suspension.

**24.** Procédé selon la revendication 23, dans lequel l'agent de stabilisation est un éther de glycol.

**25.** Procédé selon l'une quelconque des revendications 1 à 24, dans lequel les particules sont constituées de :

(a) zirconate-titanate de plomb, et/ou
(b) zirconate-titanate de plomb dopé, et/ou
(c) $BaTiO_3$, et/ou
(d) $0,95Pb(Zr_{0,52}Ti_{0,48})O_3.0,03BiFeO_3.0,02Ba(Cu_{0,5}W_{0,5})O_3$ + 0,5 % en poids de $MnO_2$ et/ou
(e) autres particules piézoélectriques.

**Fig. 1**

**Fig. 2**

**Fig. 3**

Fig. 4

**Fig. 5**

80 kV, 2 mA and 1 minute

**Fig. 6**

**Fig. 7A**

**Fig. 7B**

**Fig. 8**

**Fig. 9**

**Fig. 10A**

**Fig. 10B**

**Fig. 11**

**Fig. 12**

**Fig. 13**

**Fig. 14**

**Fig. 15**

**Fig. 16**

Fig. 17

Fig. 18

**Fig. 19**

**Fig. 20**

**Fig. 21**

**Fig. 22**

**Fig. 23**

**Fig. 24**

**Fig. 25**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20020024270 A1
- US 6349455 B1
- JP 8336967 A
- WO 60415844 A

### Non-patent literature cited in the description

- **Binning ; Smith.** Single-tube three-dimensional scanner from scanning tunneling microscopy. *Rev Sci. Instrum.,* vol. 57, 1688-1989
- **Higuchi et al.** *Sensors and Actuators A,* 1995, vol. 50, 75
- *SENSORS AND ACTUATORS,* 2000, vol. 83, 225
- *IEEE Transactions on Ultrasonics, Ferroelectrics, and Frequency Control,* 1998, vol. 45, 1178
- *IEEE Ultrasonics Symposium,* 1994, 549
- **Takeshi Morita et al.** An ultrasonic micromotor using a bending cylindrical transducer based on PZT thin film. *Sensors and Actuators A,* 1995, vol. 50, 75-80
- **Morita et al.** A Cylindrical Micro Ultrasonic Motor Using PZT Thin Film Deposited by Single Process Hydrothermal Method ($\phi$ 2.4mm, L=10 mm Stator Transducer). *IEEE Transactions on Ultrasonics, Ferroelectrics, and Frequency Control,* 1998, vol. 45 (5), 1178-1187